# EUROPEAN PATENT APPLICATION

(11) **EP 2 955 751 A1**
(43) Date of publication of application: **16.12.2015**
(21) Application number: 15170434.3
(22) Date of filing: 03.06.2015
(51) Int. Cl.: H01L 23/66, H01L 23/60, H01Q 1/40, H01Q 1/24, H01Q 1/52

(54) **HIGH FREQUENCY MODULE**

(30) Priority: 11.06.2014 JP 2014120556
(71) Applicant: Alps Electric Co., Ltd., Tokyo 145-8501 (JP)
(72) Inventor: Sugawara, Jun, Tokyo, Tokyo 145-8501 (JP); Furuyama, Yoshikazu, Tokyo, Tokyo 145-8501 (JP)
(74) Representative: Klunker . Schmitt-Nilson . Hirsch

(57) **Abstract**

A high frequency module (100) includes a wiring substrate (10) in which an electronic component (31) is mounted, and a metal shield cover (20) which is placed on the wiring substrate (10). A wiring conductor (11) through which a high frequency signal is transferred and which is coupled to the electronic component (31), a wiring electrode (13) which is coupled to the wiring conductor (11) and is provided in an outside further than the shield cover (20), and a ground electrode (15) which is coupled to the shield cover (20), are provided on the wiring substrate (10). The shield cover (20) includes a side plate (21) which is formed of a metal of a plate shape, and a leg portion (23) which is provided in the side plate (21) and is soldered to the ground electrode (15). A gap D is formed between the side plate (21) and the wiring substrate (10), and the wiring conductor (11) is disposed so as to intersect the side plate (21) in a planar view, on the wiring substrate (10) which is positioned below the gap D.

## Description

This application claims benefit of Japanese Patent Application No. 2014-120556 filed on June 11, 2014, which is hereby incorporated by reference.

The present invention relates to a high frequency module, and particularly to a high frequency module which can prevent damage due to static electricity discharge to an electronic component.

In recent years, for a high frequency module in which a high frequency circuit such as a wireless LAN is mounted, an ESD protection element for taking an electro-static discharge (ESD) measure has been used. However, being generally capacitive, an ESD protection element affects performance of a high frequency circuit. Thus, it is desirable that a high frequency module takes an ESD measure, without using an ESD protection element which affects performance of a circuit.

An electronic circuit unit which is configured to take an ESD measure without using an ESD protection element is disclosed in Japanese Unexamined Patent Application Publication No. 2012-018857. A structure of an electronic circuit unit 900 which is disclosed in Japanese Unexamined Patent Application Publication No. 2012-018857 is illustrated in Fig. 4.

The electronic circuit unit 900 includes an insulating substrate 904, and a capacitive cover 905 which covers at least a portion of a substrate surface of the insulating substrate 904. A first side surface electrode 911 and a second side surface electrode 912 are formed on a side surface of the insulating substrate 904, a leg portion 915 of the cover 905 and the first side surface electrode 911 are soldered to each other, and a protrusion 916 is formed in the cover 905 so as to face the second side surface electrode 912. Meanwhile, the first side surface electrode 911 is configured as a ground electrode of the electronic circuit unit 900. In addition, the second side surface electrode 912 is configured as a power supply electrode of the electronic circuit unit 900.

According to this configuration, the protrusion 916 which faces the second side surface electrode 912 is formed in the cover 905, and thereby a distance between the second side surface electrode 912 and the cover 905 which is configured as a ground potential becomes small, and corona discharge easily occurs. Thus, in a case in which static electricity is discharged to the second side surface electrode 912, the static electricity is appropriately discharged to the cover 905 via the protrusion 916, and it is possible to prevent an electronic circuit component or the like on the insulating substrate 904 from malfunctioning or being damaged. In addition, even in a case in which an interval between the cover 905 and the second side surface electrode 912 is wide, the static electricity is discharged to the cover 905 side via the protrusion 916, and thereby even if accuracy of a position in which the cover 905 is attached to the insulating substrate 904 is low, an electrostatic measure can be taken.

However, in a case in which an ESD measure for an electronic circuit unit 900 which is disclosed in Japanese Unexamined Patent Application Publication No. 2012-018857 is used for a wiring electrode for a high frequency circuit of a high frequency module, there is the following problem.

In the electronic circuit unit 900, a coupling capacitance is generated between a tip portion of a protrusion 916 and a second side surface electrode 912. In addition, an electrode such as the second side surface electrode 912 is coupled to a mother substrate 902 via a solder S thereby being attached. Thus, the second side surface electrode 912 is coated with the solder S, and is configured to be fixed. An amount of the solder S is not necessarily constant in a manufacturing process. As a result, a distance between a tip portion of the protrusion 916 and the second side surface electrode 912 is subject to variation. Thus, a capacitive value of a coupling capacitance which is generated between a tip portion of the protrusion 916 and the second side surface electrode 912 varies.

In a case of the electronic circuit unit 900, the second side surface electrode 912 is configured to be used as a power supply electrode, and thus even if a coupling capacitance between a tip portion of the protrusion 916 and the second side surface electrode 912 varies, performance issues do not occur in particular. However, in a case in which the second side surface electrode 912 of the electronic circuit unit 900 is used as a wiring electrode of a high frequency circuit, a coupling capacitance varies between the wiring electrode and the protrusion 916, that is, between a wiring electrode of a high frequency circuit and a ground potential. In a case in which a coupling capacitance between a wiring electrode of a high frequency circuit and a ground potential varies, the variation affects performance of a high frequency circuit. Particularly, in a case in which a high frequency circuit which is coupled to a wiring electrode is an antenna circuit, the high frequency circuit affects antenna characteristics.

The present invention provides a high frequency module which can take an ESD measure without affecting performance of the high frequency circuit.

A high frequency module of the present invention includes a wiring substrate in which an electronic component is mounted; and a metal shield cover which is placed on the wiring substrate, in which a wiring conductor through which a high frequency signal is transferred and which is coupled to the electronic component, a wiring electrode which is coupled to the wiring conductor and is provided in an outside further than the shield cover, and a ground electrode which is coupled to the shield cover, are provided on the wiring substrate, in which the shield cover includes a side plate which is formed of a metal of a plate shape, and a leg portion which is provided in the side plate and is soldered to the ground electrode, and in which a gap is formed between the side plate and the wiring substrate, and the wiring conductor is disposed so as to intersect the side plate in a planar view, on the wiring substrate which is positioned below the gap.

In the high frequency module which is configured in this way, the wiring conductor is disposed so as to intersect the side plate in a planar view, and thereby a value of a coupling capacitance between the wiring conductor and the side plate can be constant. As a result, it is possible to take an ESD measure without affecting performance of the high frequency circuit.

In addition, in the configuration, an angle which is formed by the wiring conductor and the side plate may be a right angle.

In the high frequency module which is configured in this way, an angle which is formed by the wiring conductor and the side plate is a right angle, and thereby an area at which the wiring conductor and the side plate intersect each other can be reduced in a minimum manner. For this reason, a value of a coupling capacitance between the wiring conductor and the side plate can be smallest, and a high frequency circuit can be easily designed.

In addition, in the configuration, an end portion of the leg portion may be in contact with the ground electrode.

In the high frequency module which is configured in this way, it is possible to accurately set a separation distance between the wiring conductor and the side plate.

In addition, in the configuration, an antenna may be coupled to the wiring electrode.

In the high frequency module which is configured in this way, in a case in which the antenna is coupled to the wiring electrode, power loss of a signal which is transmitted to or received from the antenna can be reduced, and static electricity can be easily discharged.

In the high frequency module of the present invention, a wiring conductor is disposed so as to intersect a side plate in a planar view, and thereby a value of a coupling capacitance between the wiring conductor and the side plate can be constant. As a result, it is possible to take an ESD measure without affecting performance of a high frequency circuit.
Fig. 1 is a perspective view illustrating an appearance of a high frequency module;
Fig. 2A and Fig. 2B are respectively a side view and a plan view of a high frequency module;
Fig. 3 is a schematic diagram illustrating a state of air discharge; and

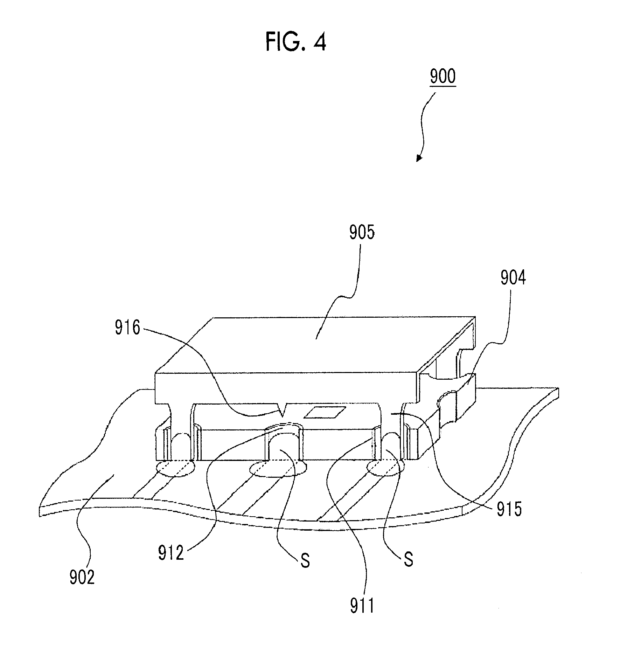

Fig. 4 is a perspective view illustrating an appearance of an electronic circuit unit according to an example of the related art.

Hereinafter, an embodiment of the present invention will be described with reference to the drawings. Meanwhile, in the present specification, unless otherwise noted, X1 of each drawing is referred to as a right side, X2 of each drawing is referred to as a left side, Y1 of each drawing is referred to as a far side, Y2 of each drawing is referred to as a front side, Z1 of each drawing is referred to as an upper side, and Z2 of each drawing is referred to as a lower side.

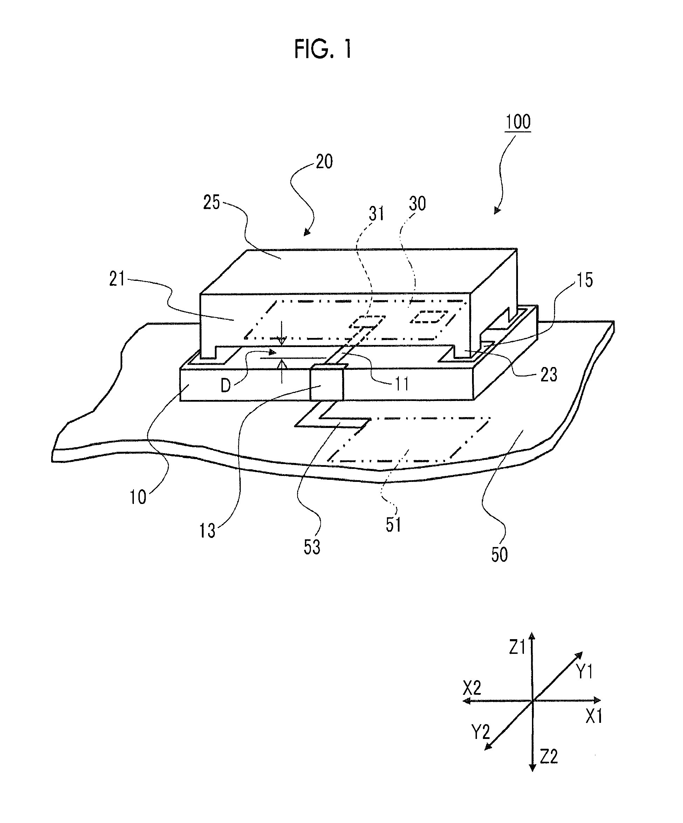

A configuration and an operation of a high frequency module 100 according to an embodiment will be described using Fig. 1 to Fig. 3.

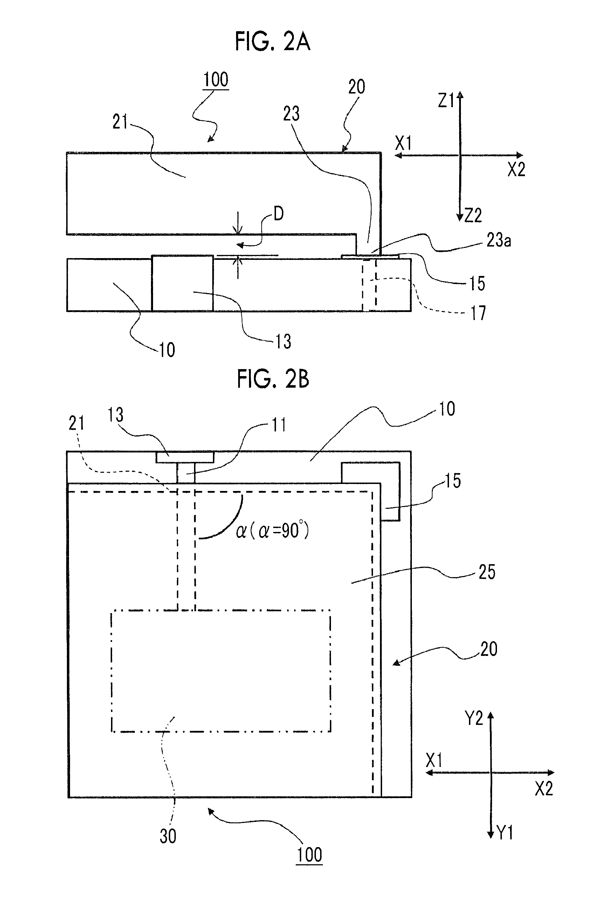

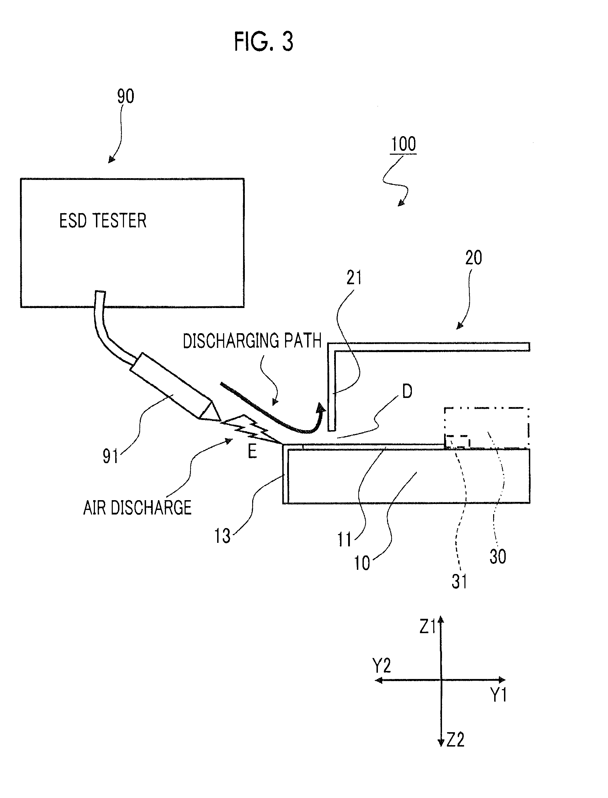

Fig. 1 is a perspective view illustrating an appearance of a high frequency module 100, and Fig. 2A and Fig. 2B are respectively a side view and a plan view of a high frequency module 100. Fig. 3 is a schematic diagram illustrating a state of air discharge with respect to the high frequency module 100.

First, a configuration of the high frequency module 100 will be described. As illustrated in Fig. 1, the high frequency module 100 includes a wiring substrate 10 in which an electronic component 31 is mounted, and a metal shield cover 20 which is placed on the wiring substrate 10.

A wiring conductor 11 through which a high frequency signal is transferred and which is coupled to the electronic component 31, a wiring electrode 13 which is coupled to the wiring conductor 11 and is provided in an outside further than the shield cover 20, and a ground electrode 15 which is coupled to the shield cover 20, are provided on the wiring substrate 10. In the high frequency module 100, a high frequency circuit 30 is configured by the electronic component 31, the wiring conductor 11, another wiring conductor which is not illustrated, and the like. The wiring electrode 13 is a terminal for antenna-coupling. Herein, the wiring electrode 13 is provided as a side surface electrode which is formed on a side surface of the wiring substrate 10, but if being coupled to the wiring conductor 11, the electrode 13 may be an electrode which is provided on a lower surface of the wiring substrate 10.

The shield cover 20 is a metal of a plate shape, and includes a top plate 25 of a rectangular shape which has a surface in parallel with the wiring substrate 10, and a side plate 21 which extends from each side of the top plate 25 and is formed of a metal of a plate shape. The shield cover 20 is attached to the wiring substrate 10 so as to cover the above-described high frequency circuit 30, and shields the high frequency circuit 30 using a high frequency shield. A plurality of leg portions 23 are provided in the side plate 21, and the leg portions 23 are soldered to the ground electrode 15 on the wiring substrate 10.

As illustrated in Fig. 1, the high frequency module 100 is attached on a mother board 50 which is included in an electronic apparatus (not illustrated). Various circuits (not illustrated) are mounted in the mother board 50, and a portion of the circuits are coupled to the high frequency module 100. In addition, an antenna 51 is mounted on the mother board 50, and the antenna 51 may be coupled to the wiring electrode 13 of the high frequency module 100 via a conductor 53 for antenna-coupling.

As illustrated in Fig. 1 and Fig. 2A, a gap D is formed between the side plate 21 and the wiring substrate 10. Then, as illustrated in Fig. 1 and Fig. 2B, the wiring conductor 11 is disposed so as to intersect the side plate 21 in a planar view, on the wiring substrate 10 which is positioned below the gap D. Particularly, it is preferable that the wiring conductor 11 is disposed in such a manner that an angle α which is formed by the wiring conductor 11 and the side plate 21 may be a right angle, as illustrated in Fig. 2B. It is enough to only produce the shield cover 20 of the high frequency module 100 in such a manner that the gap D is formed between the side plate 21 and the wiring substrate 10, and thus it is not necessary to form the side plate 21 in a particular structure, and it is easy to produce and manage the shield cover 20.

As described above, the leg portion 23 is provided in the side plate 21, and is soldered to the ground electrode 15 on the wiring substrate 10. As illustrated in Fig. 2B, the leg portion 23 is attached in such a manner that an end portion 23a thereof may be in contact with the ground electrode 15. Meanwhile, an attachment portion for being attached to the wiring substrate 10 or the like may be additionally provided in the leg portion 23, but it is necessary for the end portion 23a of the leg portion 23 which determines a height of attachment of the side plate 21 to be placed in a state of being in contact with the ground electrode 15. In addition, the ground electrode 15 is coupled to a ground pattern (not illustrated) of the mother board 50 via a through-hole 17. As a result, a potential of the shield cover 20 becomes the same potential as the ground pattern of the mother board 50.

Next, a state of air discharge with respect to the high frequency module 100 will be described. An ESD test is performed with respect to the high frequency module 100.

As illustrated in Fig. 3, an ESD test with respect to the high frequency module 100 is performed using an ESD tester 90. In the ESD tester 90, static electricity E is generated by a predetermined capacitance value and a predetermined high voltage value. The generated static electricity E is air-discharged to the wiring electrode 13 of the high frequency module 100 via a probe 91 which is attached to the ESD tester 90.

In a case in which the present invention is not applied, the static electricity E which is air-discharged to the wiring electrode 13 of the high frequency module 100 is subject to being applied to the electronic component 31 in the high frequency circuit 30 via the wiring conductor 11 from the wiring electrode 13. As a result, there is a possibility that the electronic component 31 may be damaged by static electricity. However, in a case in which the present invention is applied, as illustrated in Fig. 3, the static electricity E which is air-discharged is discharged via a portion of the wiring conductor 11, the gap D, and a discharging path from the wiring electrode 13 to the side plate 21 of the shield cover 20. Next, the static electricity E which is transferred to the shield cover 20 is guided to a ground pattern (not illustrated) of the mother board 50 via the leg portion 23 of the shield cover 20 which is illustrated in Fig. 2A, the ground electrode 15 of the wiring substrate 10, and the through-hole 17. Thus, the static electricity E is not applied to the electronic component 31 in the high frequency circuit 30. For this reason, the electronic component 31 is not damaged by an electrostatic discharge.

In this way, in the high frequency module 100, the wiring conductor 11 is disposed so as to intersect the side plate 21 in a planar view, and thereby a value of a coupling capacitance between the wiring conductor 11 and the side plate 21 can be constant. As a result, it is possible to take an ESD measure without affecting performance of the high frequency circuit 30.

In addition, an angle which is formed by the wiring conductor 11 and the side plate 21 is a right angle, and thereby an area at which the wiring conductor 11 and the side plate 21 intersect each other can be minimally reduced. For this reason, a value of a coupling capacitance between the wiring conductor 11 and the side plate 21 can be smallest, and the high frequency circuit 30 can be easily designed.

In addition, the end portion 23a of the leg portion 23 may be in contact with the ground electrode 15, and thereby, it is possible to accurately set a distance between the wiring conductor 11 and the side plate 21, that is, a separated distance of the gap D.

In addition, in a case in which the antenna 51 is coupled to the wiring electrode 13, power loss of a signal which is transmitted to or received from the antenna 51 can be reduced, and static electricity can be easily discharged.

As illustrated above, in the high frequency module of the present invention, the wiring conductor is disposed so as to intersect the side plate in a planar view, and thereby the value of a coupling capacitance between the wiring conductor and the side plate can be constant. As a result, it is possible to take an ESD measure without affecting performance of a high frequency circuit.

As described above, the high frequency module 100 according to the embodiment of the present invention is described, but the present invention is not limited to the above-described embodiment, and can be implemented by various modifications within a range without departing from the gist.

It should be understood by those skilled in the art that various modifications, combinations, sub-combinations, and alterations may occur depending on design requirements and other factors insofar as they are within the scope of the appended claims of the equivalents thereof.

## Claims

1. A high frequency module (100) comprising:
a wiring substrate (10) in which an electronic component (31) is mounted; and
a metal shield cover (20) which is placed on the wiring substrate (10),
wherein, a wiring conductor (11) through which a high frequency signal is transferred and which is coupled to the electronic component (31), a wiring electrode (13) which is coupled to the wiring conductor (11) and is provided in an outside further than the shield cover (20), and a ground electrode (15) which is coupled to the shield cover (20), are provided on the wiring substrate (10),
wherein the shield cover (20) includes a side plate (21) which is formed of a metal of a plate shape, and a leg portion (23) which is provided in the side plate (21) and is soldered to the ground electrode (15), and
wherein a gap is formed between the side plate (21) and the wiring substrate (10), and the wiring conductor (11) is disposed so as to intersect the side plate (21) in a planar view, on the wiring substrate (10) which is positioned below the gap.

2. The high frequency module according to Claim 1, wherein an angle which is formed by the wiring conductor (11) and the side plate (21) is a right angle.

3. The high frequency module according to Claim 1 to 2, wherein an end portion (23a) of the leg portion (23) is in contact with the ground electrode (15).

4. The high frequency module according to Claims 1 to 3, wherein an antenna is coupled to the wiring electrode (13).
